(19) **Europäisches Patentamt**

**European Patent Office**

**Office européen des brevets**

(11) Veröffentlichungsnummer: **0 025 102**
**B1**

(12) **EUROPÄISCHE PATENTSCHRIFT**

(45) Veröffentlichungstag der Patentschrift:
**31.08.83**

(21) Anmeldenummer: **80104216.9**

(22) Anmeldetag: **18.07.80**

(51) Int. Cl.³: **H 03 K 19/177,** H 03 K 19/091,
H 01 L 27/02

(54) **Hochintegriertes PLA.**

(30) Priorität: **21.08.79 US 68377**

(43) Veröffentlichungstag der Anmeldung:
**18.03.81 Patentblatt 81/11**

(45) Bekanntmachung des Hinweises auf die Patenterteilung:
**31.08.83 Patentblatt 83/35**

(84) Benannte Vertragsstaaten:
**DE FR GB**

(56) Entgegenhaltungen:

**EP-A-0 017 668**
**IBM TECHNICAL DISCLOSURE BULLETIN, Band 18, Nr. 10, März 1976, New York, J.R. CAVALIERE et al.: «Current Switch Read-Only Programmable Logic Array», Seiten 3245 bis 3248**

(73) Patentinhaber: **International Business Machines Corporation, Old Orchard Road, Armonk, N.Y. 10504 (US)**

(72) Erfinder: **Davis, James W., 881 SW 15th St., Boca Raton Florida 33432 (US)**
Erfinder: **Jones, Frank D., 17 Kings Drive, Wallkill New York 12589 (US)**

(74) Vertreter: **Rudolph, Wolfgang, Schönaicher Strasse 220, D-7030 Böblingen (DE)**

Hochintegriertes PLA

Die Erfindung betrifft ein hochintegriertes PLA mit UND- und ODER-Matrizen aus bipolaren Transistoren, wobei gesonderte epitaxiale Wannen in isolierter Anordnung vorhanden sind, die je als gemeinsamer Kollektor für die jeweils darauf gebildeten bipolaren Transistoren entsprechend der unter Artikel 54 Absatz 3 fallenden EP 79 105 167.5 dienen.

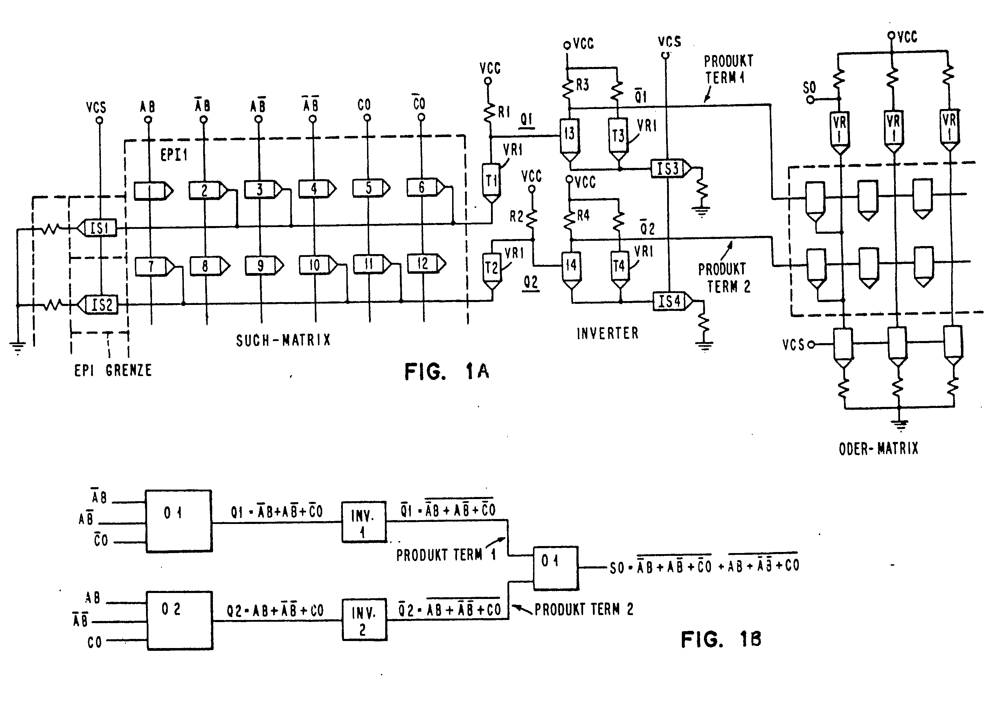

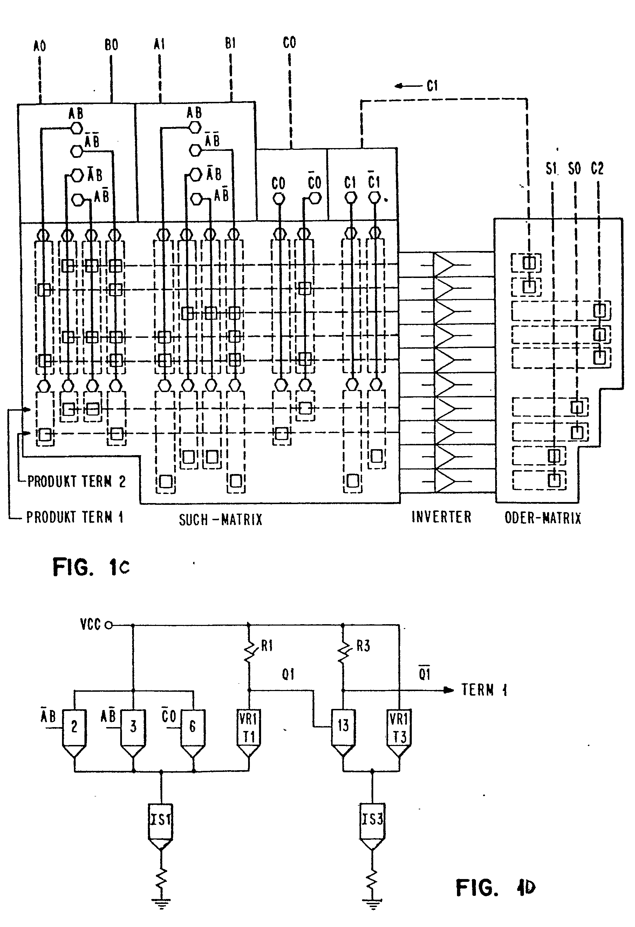

PLAs, deren ODER- und UND-Matrix aus bipolaren Transistoren in hochintegrierter Technik bestehen, sind grundsätzlich bekannt. Ein solches bekanntes PLA ist in den Figuren 1A bis 1D dargestellt, wobei in Fig. 1A die Suchmatrix, Inverterschaltungen und die ODER-Matrix eines konventionell emittergekoppelten bipolaren PLAs gezeigt sind. In der Fig. 1B sind in einem Funktionsblockdiagramm die logischen Operationen angegeben, die mit Hilfe des bekannten, in Fig. 1A dargestellten PLA durchgeführt werden können. In Fig. 1C ist die Realisierung und die relative physikalische Grösse der in Fig. 1A dargestellten Schaltkreise dargestellt und in Fig. 1D eine Schaltung, die die Emitterkopplung der Schaltung nach Fig. 1A zeigt.

Im nachfolgenden soll nun kurz die Wirkungsweise des in Fig. 1A dargestellten, bekannten PLAs beschrieben werden. Über nicht dargestellte Decodierer gelangen Signale $\overline{AB}$, $A\overline{B}$ und $\overline{CO}$ über externe, nicht dargestellte Decoder an die Eingänge, d.h. an die Basen der Transistoren 2, 3 und 6. Sind die Signale eines oder mehrerer dieser Eingänge hoch, dann wird der Strom zur Stromsenke IS1 und Widerstand R1 über VR1-T1 aufgeteilt und wird von Vcc über die Transistoren mit hochliegenden Eingängen geleitet. Dadurch wird ein logischer Zustand "1" am Punkt Q1 erzeugt. Der Stromweg ist nur dann über R1 und VR1-T1, wenn alle Eingangssignale der Transistoren 2, 3 und 6 sich in ihrem niedrigen Zustand befinden. Der Strom über R1 erzeugt den logischen Zustand "0" am Punkte Q1. Der logische Ausdruck für den Punkt Q1 kann wie folgt angegeben werden:

$$\overline{A}B + A\overline{B} + \overline{C}O.$$

Um diese gewünschten Produktterme zu erhalten, muss Q1 invertiert werden, wodurch folgender Ausdruck entsteht:

$$\overline{Q1} = \overline{A}B + A\overline{B} + \overline{C}O.$$

Die Fign. 1A bis 1D korrelieren wie folgt. Die Funktion "SO" in Fig. 1C ist in den Fign. 1A und 1B mit den Produkttermen 1 und 2 erweitert. Die Fig. 1D zeigt das Produkt Term 1 der Fign. 1A bis 1C. In Fig. 1A stellt EPI 1 die gemeinsame Kollektorverbindung oder Wanne der Transistoren 2, 3 und 6 der Fig. 1D und alle anderen Eingangstransistoren der Suchmatrix dar. Alle anderen, in den Figuren übereinstimmenden Teile sind in allen drei Figuren gleich gekennzeichnet.

Obwohl das beschriebene PLA einwandfrei arbeitet, hat es den Nachteil, dass eine höhere Integrationsdichte und eine höhere Leistungsfähigkeit nicht erreichbar ist und dass ausserdem der Leistungsverbrauch noch zu hoch ist.

Der Erfindung liegt deshalb die Aufgabe zugrunde, ein hochintegriertes PLA mit bipolaren Transistoren zu schaffen, das eine Reduzierung der verwendeten Schaltkreise erlaubt und damit den Leistungsverlust reduziert und jedoch mindestens die Leistungsfähigkeit der bisher bekannten PLAs aufweisen soll.

Die erfindungsgemässe Lösung ergibt sich aus dem Kennzeichen des Patentanspruchs 1.

Weitere Lösungen sind in dem Kennzeichen der Patentansprüche 2 bis 4 charakterisiert.

Dadurch, dass die Inverterschaltkreise zwischen der UND- und ODER-Matrix wegfallen, ist eine Verringerung der erforderlichen Schaltungen für ein PLA erreicht worden, woraus sich eine Verminderung der Leistungsaufnahme ergibt. Ausserdem ist die Integrationsdichte durch den erfindungsgemässen Aufbau eines PLAs wesentlich erhöht worden und die Komplexität der Gesamtschaltung verringert worden, obwohl die Leistungsfähigkeit genau so gross ist wie bei den bisher bekannten umfangreicheren und nicht so hoch integrierten PLAs mit bipolaren Transistoren.

Die Erfindung wird nun anhand von in den Zeichnungen dargestellten Ausführungsbeispielen näher beschrieben.

In der Zeichnung bedeuten:

Fig. 1A bis 1D ein bekanntes PLA und
Fign. 2A bis 2F zeigen den Schaltungsaufbau, den integrierten Aufbau und die Wirkungsweise des erfindungsgemässen PLAs.

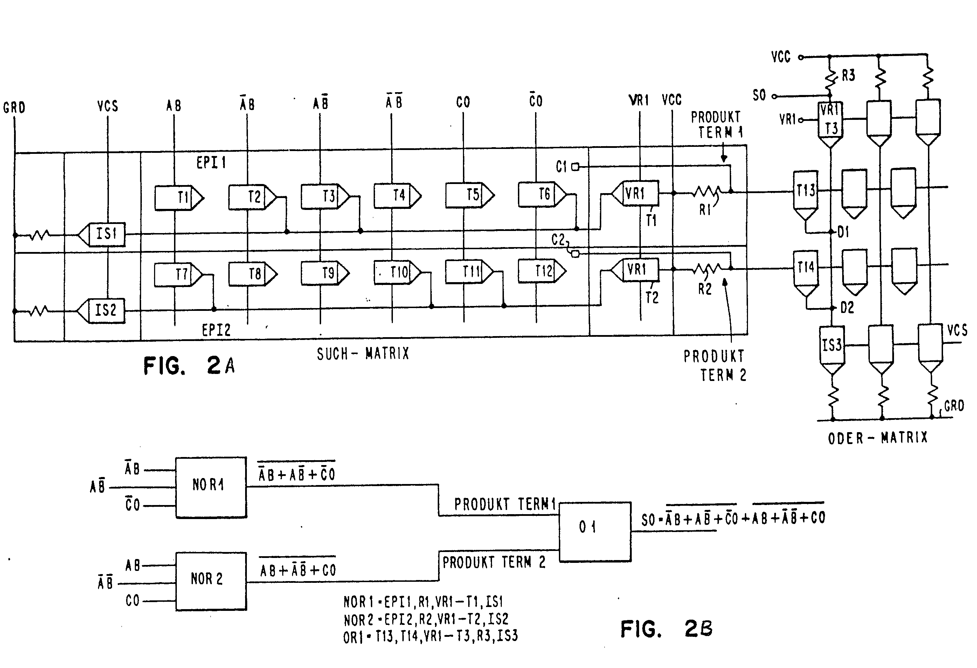

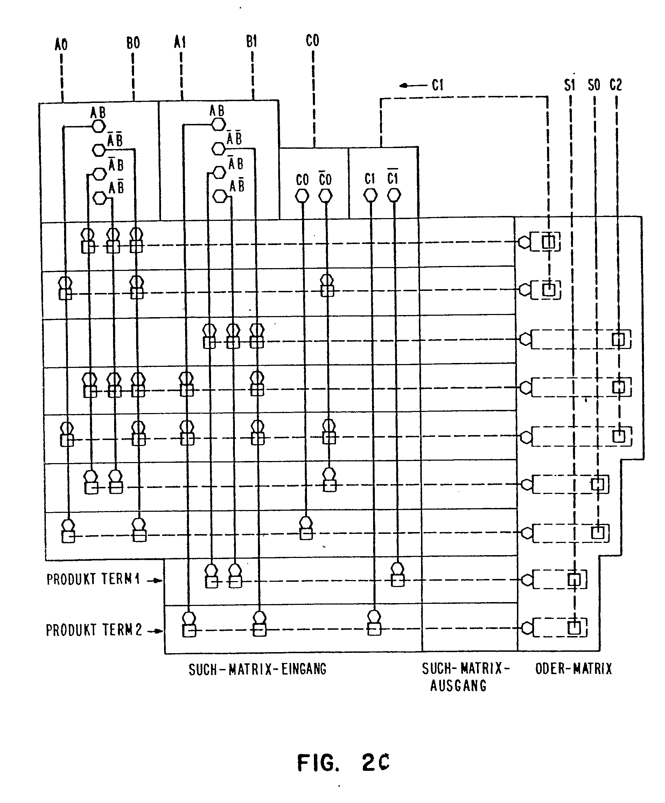

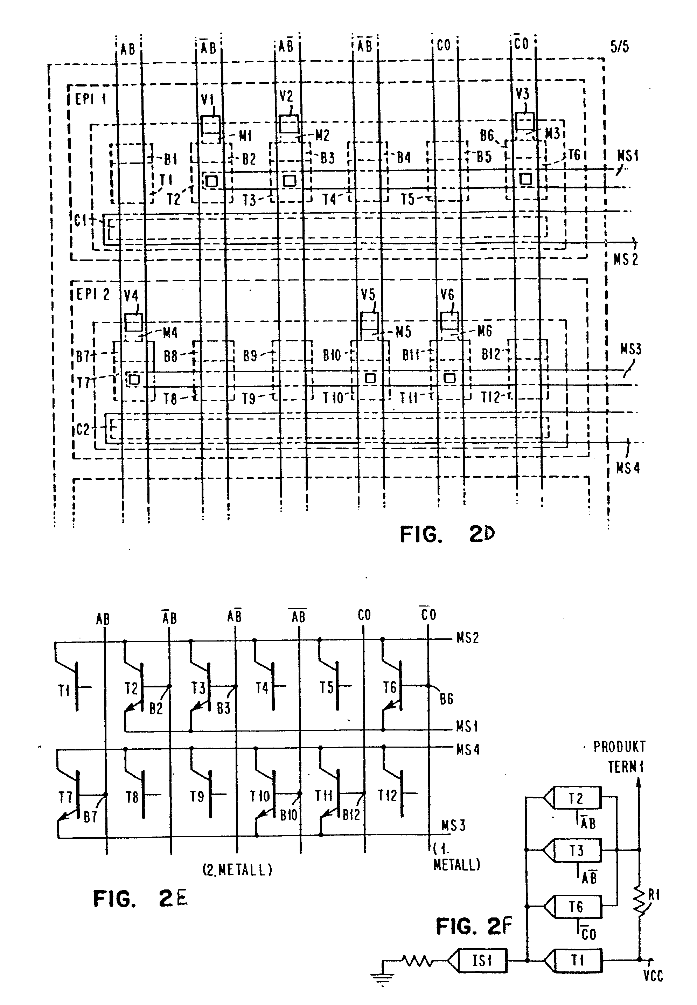

Die Fign. 2A und 2B zeigen Schaltkreis- und Logikdiagramme eines in Fig. 2C dargestellten PLAs für die Funktion SO. Die Fig. 2F ist eine Erweiterung des Produktterms 1 der Fign. 2A bis C. Die Fig. 2D und E zeigen einen Ausschnitt des tatsächlichen physikalischen Designs der Eingangstransistoren der Suchmatrix. Die diskreten Produktterme der Fign. 2A und B sind voneinander isoliert in zwei separaten Kollektorwannen EPI 1 und EPI 2 der Fign. 2A und 2D in der Eingangstransistorsektion der Suchmatrix. Dadurch wird eine Widerstandsverbindung zu den gemeinsamen Kollektoren ermöglicht.

Die Fign. 2A, 2D und 2F korrelieren wie folgt:
Fig. 2F repräsentiert das Produkt Term 1 der Fign. 2A und 2D. Die Eingangssignale in Fig. 2F werden der Matrix über die zweite Metallschicht zugeführt. Die Eingänge werden an die Eingangstransistoren T2, T3 und T6 gemäss Fig. 2F über die Durchführungslöcher V1, V2 und V3 zur Verbindung mit der ersten Metallschicht auf die Basen der Eingangstransistoren wie folgt gegeben: V1-M1-B2, V2-M2-B3 und V3-M3-B6 (Fign. 2D und E); dies sind Durchführungslöcher für die erste Metallschicht zur Basis. Der gemeinsame Kollektor C1 der Transistoren T2, T3 und T6 ist mit der ersten Metallschicht MS1 gemäss Fig. 2D, 2E mit dem Widerstand R1 verbunden. Der gemeinsame Emitter dieser Transistoren T2, T3 und T6 ist über die erste Metallschicht MS1 gemäss Fig. 2D und gemäss Fig. 2E mit dem Emitter von VR1-T1 und dem Kollektor von IS1 verbunden.

Das bekannte, in Fig. 1C dargestellte PLA kann die identischen Funktionen wie das gemäss Fig. 2C ausführen, wodurch ganz offensichtlich wird, dass das PLA gemäss Fig. 2C eine wesentlich höhere Integrationsdichte zulässt, weil drei Transistoren und drei Widerstände für die Inverterstufe entfallen können, dass die Leistungsfähigkeit des PLA nach Fig. 2C grösser ist, weil die Signalverzögerung der Inverterstufe entfällt und dass ebenfalls die Leistungsaufnahme verringert wurde, weil die Inverterstufen entfallen und somit keine Leistung mehr aufnehmen. Auch das physikalische Design wurde dahingehend verbessert, dass nicht mehr, wie in Fig. 1C dargestellt, die langen Basisleitungen für die codierten Eingangsbits erforderlich sind, wodurch die kapazitive Belastung verringert wird und ausserdem der rein ohmsche Widerstand der Leitungen ebenfalls verringert wird.

## Patentansprüche

1. Hochintegriertes PLA mit UND- und ODER--Matrizen aus bipolaren Transistoren zur Verknüpfung logischer Eingangsgrössen und Bildung von Produkttermen, dadurch gekennzeichnet, dass die Transistoren für jedes Produktterm in einer gesonderten epitaxialen Wanne (EPI 1 und EPI 2) isoliert angeordnet sind und dass zwischen den gemeinsamen Kollektoren (C1 und C2) einer Wanne (EPI 1 oder EPI 2) und dem Kollektor eines Referenztransistors (VR1-T1 oder VR1-T2) ein Widerstand (R1 oder R2) angeordnet ist, der ausserdem direkt mit dem Eingang der ODER-Matrix verbunden ist.

2. Hochintegriertes PLA nach Anspruch 1, dadurch gekennzeichnet, dass in einer ersten isolierten epitaxialen Region oder Wanne (EPI 1 oder EPI 2) ein gemeinsamer Kollektor (C1 oder C2) einer Anzahl bipolarer Transistoren (T1 bis T6 oder T7 bis T12) angeordnet ist, dass die davon selektierten Transistoren mit ihrem Emitter mit einer gemeinsamen Emitterleitung verbunden sind und ihre Basiselektroden mit entsprechenden Eingangssignalquellen, dass ein bipolarer Referenztransistor (VR1-T1 oder VR1-T2), dessen Emitter mit einer gemeinsamen Emitterleitung verbunden ist und dessen Basis mit einem Referenzpotential (VR1) beaufschlagt ist und dessen Kollektor mit einem Kollektorpotential (VCC) beaufschlagt ist, über einen Widerstand (R1 oder R2) direkt mit dem Eingang der ODER-Matrix verbunden ist.

3. Hochintegriertes PLA nach den Ansprüchen 1 und 2, dadurch gekennzeichnet, dass die epitaxiale Region (EPI) über einen Anschlusspunkt (C1 oder C2) mit dem Ausgang der Suchmatrix verbunden ist und somit mit dem Kollektorpotential beaufschlagt wird, und dass dieses Potential direkt auf die Basiselektroden von Eingangstransistoren (T13 und T14) der ODER-Matrix gegeben wird.

4. Hochintegriertes PLA nach den Ansprüchen 1 bis 3, dadurch gekennzeichnet, dass mehrere epitaxiale Regionen, Wannen oder Röhren (EPI) in einer Matrix parallel verlaufen.

## Claims

1. Highly integrated PLA with AND and OR matrices of bipolar transistors for combining logic inputs and for forming product terms, characterized in that the transistors for each product term are isolated in a separate epitaxial tub (EPI 1 and EPI 2), and that between the common collectors (C1 and C2) of a tub (EPI 1 or EPI 2) and the collector of a reference transistor (VR1-T1 or VR1-T2) a resistor (R1 or R2) is arranged which is furthermore directly connected to the input of the OR matrix.

2. Highly integrated PLA as claimed in claim 1, characterized in that in a first isolated epitaxial region or tub (EPI 1 or EPI 2) a common collector (C1 or C2) of a number of bipolar transistors (T1 to T6 or T7 to T12) is arranged, that the transistors selected thereby are connected with their emitter to a common emitter line, and with their base electrodes to corresponding input signal sources, that a bipolar reference transistor (VR1-T1 or VR1-T2) whose emitter is connected to a common emitter line, and whose base is applied with a reference potential (VR1), and whose collector is applied with a collector potential (VCC), is directly connected via a resistor (R1 or R2) to the input of the OR matrix.

3. Highly integrated PLA as claimed in claim 1 to 2, characterized in that the epitaxial region (EPI) is connected via a connecting point (C1 or C2) to the output of the search matrix and thus applied with the collector potential, and that this potential is directly applied to the base electrodes of input transistors (T13 and T14) of the OR matrix.

4. Highly integrated PLA as claimed in claims 1 to 3, characterized in that several epitaxial regions, tubs or tubes (EPI) are arranged in parallel in a matrix.

## Revendications

1. Circuit logique programmable à intégration élevée comportant des matrices ET et OU, lesquelles sont constituées de transistors bipolaires permettant de chaîner les entrées logiques et de former les termes du produit, caractérisé en ce que, les transistors de chaque terme du produit sont montés de façon isolée dans une région épitaxiale particulière (EPI 1 et EPI 2), et en ce qu'on a une résistance (R1 ou R2) entre d'une part les collecteurs communs (C1 et C2) d'une poche épitaxiale (EPI 1 ou EPI 2), et d'autre part le collecteur d'un transistor de référence (VR1-T1 ou VR1-T2), laquelle résistance est, en outre, directement connectée à l'entrée de la matrice OU.

2. Circuit programmable logique à intégration élevée selon la revendication 1, caractérisé en ce qu'on a dans une première région ou poche épitaxiale isolée (EPI 1 ou EPI 2), un collecteur (C1 ou C2) commun à un certain nombre de transistors bipolaires (T1 à T6 ou T7 à T12), en ce que les transistors ainsi sélectionnés sont connectés à travers leur émetteur à une ligne d'émetteur commune, et leurs électrodes de base aux sources des signaux d'entrée correspondants, en ce qu'un transistor de référence bipolaire (VR1-T1 ou VR1-T2), dont l'émetteur est relié à une ligne d'émetteurs dont la base reçoit un potentiel de référence (CR1), et dont le collecteur reçoit un potentiel de collecteur (VCC), est par l'intermédiaire d'une résistance (R1 ou R2) directement connectée à l'entrée de la matrice OU.

3. Circuit programmable logique selon les revendications 1 et 2, caractérisé en ce que, la région épitaxiale (EPI) est reliée via un point de connexion (C1 ou C2), à une sortie de la matrice de recherche, et reçoit donc le potentiel du collecteur, et en ce que ce potentiel alimente directement les électrodes de base des transistors d'entrée (T13 et T14) de la matrice OU.

4. Circuit programmable logique selon les revendications 1 à 3, caractérisé en ce que plusieurs régions, poches ou tubes épitaxiaux (EPI) sont disposés en parallèle dans une matrice.

FIG. 1A

ODER-MATRIX

PRODUKT TERM 1

PRODUKT TERM 2

INVERTER

SUCH-MATRIX

EPI GRENZE

$S0 \cdot \overline{\overline{AB} + A\overline{B} + \overline{C}0} + AB + \overline{A}\overline{3} + C0$

FIG. 1B

$\overline{Q1 \cdot \overline{AB} + A\overline{B} + \overline{C}0}$

PRODUKT TERM 1

$\overline{Q2 \cdot AB + \overline{A}\overline{B} + C0}$

PRODUKT TERM 2

$Q1 \cdot \overline{AB} + A\overline{B} + \overline{C}0$

$Q2 \cdot AB + \overline{A}\overline{B} + C0$

INV. 1

INV. 2

O 1

O 2

**FIG. 1c**

AO  BO  A1  B1  CO

C1

AB
ĀB̄
ĀB
AB̄

AB
ĀB̄
ĀB
AB̄

CO  C̄O    C1  C̄1

S1  S0  C2

PRODUKT TERM 2

PRODUKT TERM 1     SUCH-MATRIX          INVERTER    ODER-MATRIX

**FIG. 1c**

VCC

R1        R3

Q1              Q̄1
                    → TERM 1

ĀB [2]  AB̄ [3]  C̄O [6]   VR1 T1   [13]   VR1 T3

IS1                IS3

**FIG. 1D**

FIG. 2A

SUCH - MATRIX

GRD   VCS   AB   ĀB   AB̄   ĀB̄   CO   C̄O   VR1 VCC

EPI1

T1  T2  T3  T4  T5  T6   VR1   R1

IS1

C1   PRODUKT TERM 1

C2

IS2

T7  T8  T9  T10  T11  T12   VR1   R2

EPI2

VCC
SO
VR1

R3

VR1 T3

T13   D1

T14   D2

IS3   VCS

GRD

ODER - MATRIX

PRODUKT TERM 2

0 025 102

FIG. 2B

ĀB
AB̄      NOR1    ‾ĀB+AB̄+C̄O‾
C̄O

AB
ĀB̄     NOR2    ‾AB+ĀB̄+CO‾
CO

PRODUKT TERM1

PRODUKT TERM2

0 1    SO·‾ĀB+AB̄+C̄O‾ + ‾AB+ĀB̄+CO‾

NOR1 ≡ EPI1,R1,VR1—T1,IS1
NOR2 ≡ EPI2,R2,VR1—T2,IS2
OR1 ≡ T13,T14,VR1—T3,R3,IS3

FIG. 2C

FIG. 2D

FIG. 2E

FIG. 2F